# EUROPEAN PATENT SPECIFICATION

(11) **EP 2 550 899 B1**
(45) Date of publication and mention of the grant of the patent: **11.02.2015**
(21) Application number: 12165422.2
(22) Date of filing: 25.04.2012
(51) Int. Cl.: A47B 88/04, H05K 7/14

(54) **Installation device for slide assembly**
Installationsvorrichtung für eine Schiebeanordnung
Dispositif d'installation d'un ensemble coulissant

(30) Priority: 27.07.2011 TW 100126751
(43) Date of publication of application: 30.01.2013
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Huang, Chien-Li, Kaohsiung City (TW); Wang, Chun-Chiang, Kaohsiung City (TW)
(74) Representative: Viering, Jentschura & Partner Patent- und Rechtsanwälte

(56) References cited:
- EP-A1- 2 123 193
- DE-U1-202005 018 457
- US-A1- 2008 246 378

## Description

### FIELD OF THE INVENTION

The present invention relates to an installation device for a slide assembly, and more particularly to a retaining member which is engaged with an installation member of an exterior equipment and the installation member can be easily released.

### BACKGROUND OF THE INVENTION

A conventional installation device for a slide assembly is disclosed in U.S. Patent No. 6,938,967, with the title of "Telescoping slide assembly" to Dubon and generally includes a chassis 12, multiple mounting posts 14 connected to two sides of the chassis, a telescoping slide assembly 10, and a post-locking latch 66, wherein the mounting slide elements 24 of the slide assembly has multiple slots 16 and the post-locking latch is installed to the mounting slide element and a part of the post-locking latch extends into one of the slots. When in assembling, each mounting post is inserted in each slot and one of the mounting posts is positioned by the post-locking latch. By this arrangement, the chassis is securely connected to the mounting slide elements.

However, when the two sides of the chassis are connected to a rack by two rails, the chassis may impact the post-locking latch when the chassis is moved relative to the slide assembly or vibration from the operation site. If the post-locking latch is not strong enough to bear the impact, the post-locking latch is easily damaged.

The present invention intends to provide an installation device for a slide assembly to improve the shortcoming mentioned above.

### SUMMARY OF THE INVENTION

The present invention relates to an installation device for a slide assembly and comprises a first rail, a second rail and a retaining member. The second rail is longitudinally movable relative to the first rail and has an opening, a first contact portion, a second contact portion and multiple holes including at least a first installation hole and a second installation hole. The first contact portion extends from an inner wall of the opening. The first installation hole is located between the opening and the second contact portion. The retaining member has a base contacting the first contact portion of the second rail, a release portion extending from the base, a bent portion extending from the release portion and connected with an arm and a resilient portion. The arm contacts the second rail so that the release portion is located away from the second rail. The arm extends from the bent portion and beyond the first installation hole of the second rail. The arm has a retaining hole and a positioning portion, wherein the retaining hole is located corresponding to the first installation hole of the second rail, and the positioning portion is located corresponding to the second contact portion of the second rail. The resilient portion extends from the arm and toward the release portion. The resilient portion connected to the second rail and provides a resilient force to keep the retaining hole of the arm facing the first installation hole of the second rail.

The first installation hole of the second rail is engaged with a first installation member of an exterior apparatus. The second installation hole of the second rail is engaged with a second installation member of the exterior equipment. The retaining hole of the arm of the retaining member accommodates the first installation member. The positioning portion of the arm contacts the second contact portion of the second rail. The first installation member is located in the first installation hole by the retaining member.

When a force is applied to the release portion, the arm of the retaining member is moved relative to the second rail and the positioning portion of the retaining member is disengaged from the second contact portion of the second rail, so that the first installation member is released from the first installation hole of the second rail and the retaining hole of the retaining member.

Preferably, the base of the retaining member has a notch which is located corresponding to the first contact portion of the second rail.

Preferably, the arm of the retaining member has two wings respectively on two sides thereof.

Preferably, the first contact protrusion of the second rail is an L-shaped protrusion.

Preferably, the second contact portion of the second rail is a hole and the positioning portion of the retaining member is inserted into the hole.

Preferably, the retaining hole of the retaining member has a stop protruding from the inside thereof and the stop is located above the first installation hole of the second rail.

Preferably, the second installation hole has a protrusion extending from an inner wall thereof.

The primary object of the present invention is to provide an installation device wherein the retaining member is easily engaged with or disengaged from the installation member of an exterior apparatus. The retaining member is fixed to the second rail by riveting which is less expensive and easy.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 is an exploded view to show the installation device of the present invention;
Fig. 2 is a perspective view to show the installation device of the present invention;
Fig. 3 is a perspective view to show an exterior equipment is connected to the rail of the installation device of the present invention;
Fig. 4 is a partial view to show the exterior equipment is connected to the rail of the installation device of the present invention, and
Fig. 5 shows that the installation device of the present invention is in released status.

### DETAILED DESCRIPTION OF THE PREFERRED EMBODIMENT

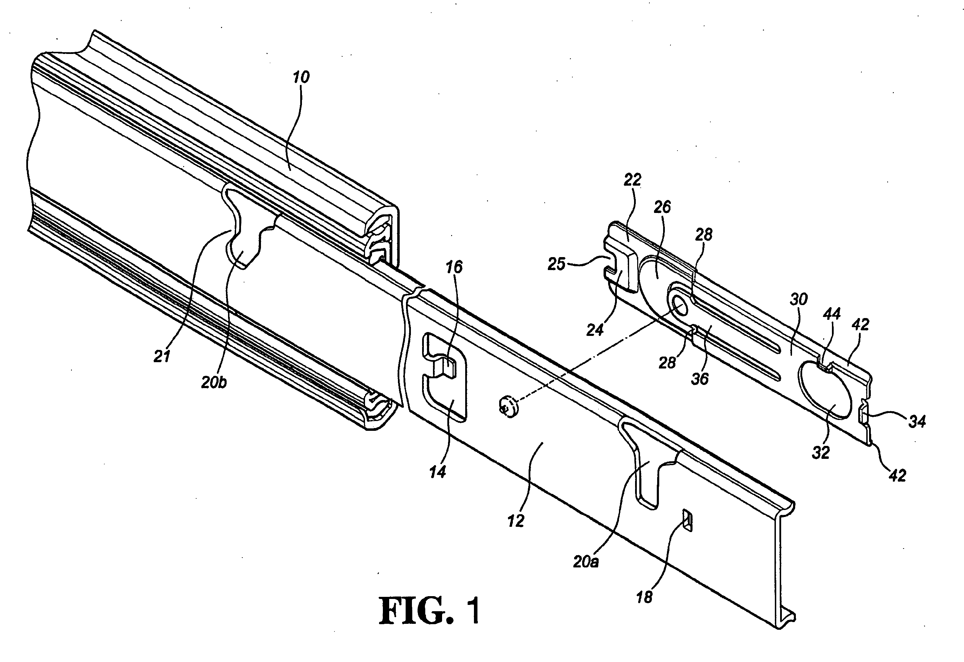

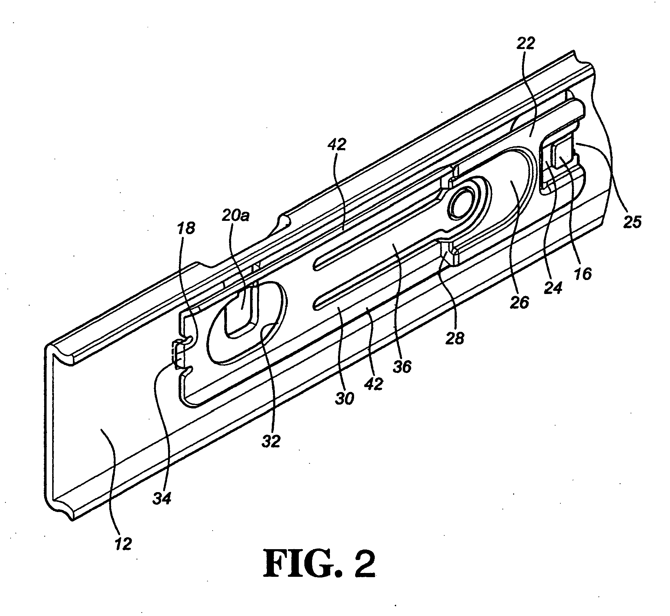

Referring to Figs. 1 and 2, the installation device of a slide assembly of the present invention comprises a first rail 10 and a second rail 12 which is longitudinally movable relative to the first rail 10. The second rail 12 has an opening 14, a first contact portion 16, a second contact portion 18 and multiple holes including at least a first installation hole 20a and a second installation hole 20b. The first contact portion 16 extends from an inner wall of the opening 14 and is an L-shaped protrusion. The second contact portion 18 of the second rail 12 is a hole. The first installation hole 20a is located between the opening 14 and the second contact portion 18. The second installation hole 20b is located at a distance from the first installation hole 20a. The second installation hole 20b has a protrusion 21 extending from an inner wall thereof.

A retaining member 22 has a base 24 contacting the first contact portion 16 of the second rail 12 and the base 24 of the retaining member 22 has a notch 25 which is located corresponding to the first contact portion 16 of the second rail 12. A release portion 26 extends from the base 24. A bent portion 28 extends from the release portion 26 and is connected with an arm 30. As shown in Fig. 2, a part of the bent portion 28 and the arm 30 contact the second rail 12 so that the release portion 26 is located away from the second rail 12.

The arm 30 extends from the bent portion 28 and beyond the first installation hole 20a of the second rail 12. The arm 30 has a retaining hole 32 and a positioning portion 34. The retaining hole 32 is located corresponding to the first installation hole 20a of the second rail 12, and the positioning portion 34 is located corresponding to the second contact portion 18 of the second rail 12.

A resilient portion 36 extends from the arm 30 and toward the release portion 26. The resilient portion 36 is connected to the second rail 12 by rivets and provides a resilient force to keep the retaining hole 32 of the arm 30 facing the first installation hole 20a of the second rail 12.

The arm 30 of the retaining member 22 has two wings 42 respectively on two sides thereof so as to reinforce the structure of the arm 30 to avoid from bending.

The retaining hole 32 of the retaining member 22 has a stop 44 protruding from the inside thereof and the stop 44 is located above the first installation hole 20a of the second rail 12.

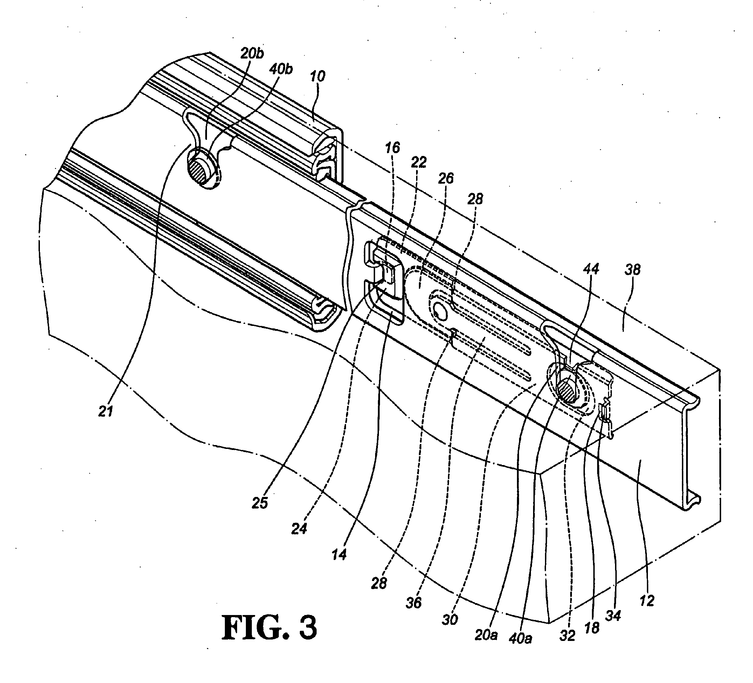

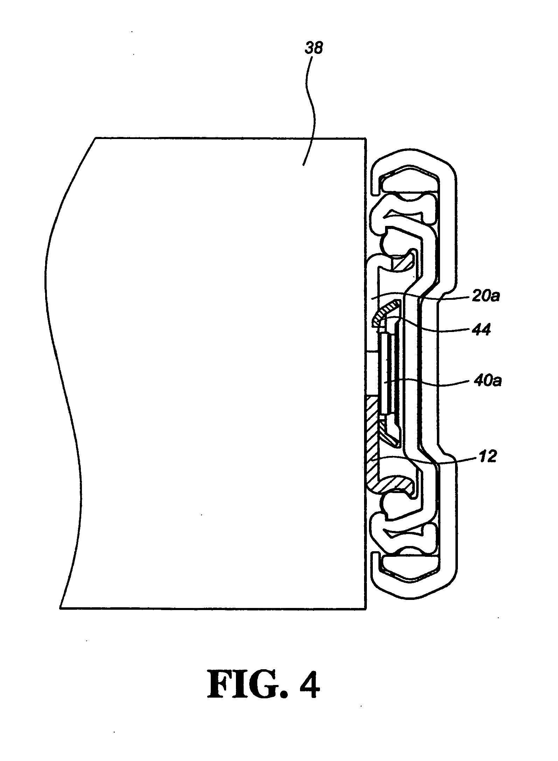

As shown in Figs. 3 and 4, the sequence of installation, preferably, the second installation member 40b of the exterior equipment 38 is first engaged with the second installation hole 20b of the second rail 12, and then the first installation member 40a of the exterior equipment 38 is engaged with the first installation hole 20a of the second rail12. Therefore, when the first installation member 40a of the exterior equipment 38 is positioned in the first installation hole 20a of the second rail 12, the second installation member 40b of the exterior equipment 38 is engaged with the second installation hole 20b of the second rail 12 and stopped by the protrusion 21 to avoid the second installation member 40b of the exterior equipment 38 from protruding upward from the second installation hole 20b, so that the exterior equipment 38 is ensured to be connected to the second rail 12. In this embodiment, the retaining hole 32 of the retaining member 22 accommodates the first installation member 40a, and the positioning portion 34 of the retaining member 22 contacts the second contact portion 18 of the second rail 12. By this way, the retaining member 22 and the second rail 12 are connected to each other stably. The first installation member 40a is mounted by the retaining hole 32 of the retaining member 22, so that the first installation member 40a is located in the first installation hole 20a by the retaining member 22 and cannot disengage from the second rail 12. The stop 44 of the retaining hole 32 of the retaining member 22 may contact the top of the first installation member 40a to reinforce the contact.

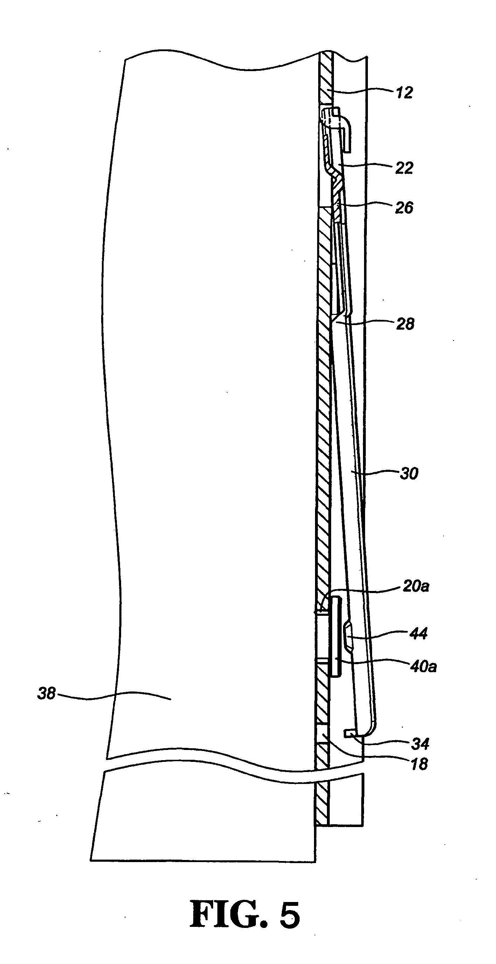

As shown in Fig. 5, when a force is applied to the release portion 26, the bent portion 28 of the retaining member 22 is against the second rail 12 to function as a fulcrum, so that the arm 30 on the other side of the contact point may move away relative to the second rail 12. The positioning portion 34 of the retaining member 22 is disengaged from the second contact portion 18 of the second rail 12, so that the first installation member 40a is released from the retaining hole 32 of the retaining member 22. The first installation member 40a is released upward from the first installation hole 20a of the second rail 12 and does not interfere the stop 44. After the first installation member 40a of the exterior equipment 38 is released upward from the first installation hole 20a of the second rail 12, the second installation member 40b can be released upward from the second installation hole 20b of the second rail 12 by the inclined exterior equipment 38 and without interference with the protrusion 21 in the second installation hole 20b.

While we have shown and described the embodiment in accordance with the present invention, it should be clear to those skilled in the art that further embodiments may be made without departing from the scope of the present invention.

## Claims

1. An installation device for a slide assembly, comprising:
a first rail (10);
a second rail (12) longitudinally movable relative to the first rail (10), the second rail (12) having an opening (14), a first contact portion (16), a second contact portion (18) and multiple holes including at least a first installation hole (20a) and a second installation hole (20b), the first contact portion (16) extending from an inner wall of the opening (14), the first installation hole (20a) located between the opening (14) and the second contact portion (18);
a retaining member (22) having a base (24) contacting the first contact portion (16) of the second rail (12), a release portion (26) extending from the base (24), a bent portion (28) extending from the release portion (26) and connected with an arm (30), the arm (30) contacting the second rail (12) so that the release portion (26) is located away from the second rail (12);
the arm (30) extending from the bent portion (28) and beyond the first installation hole (20a) of the second rail (12), the arm (30) having a retaining hole (32) and a positioning portion (34), the retaining hole (32) located corresponding to the first installation hole (20a) of the second rail (12), the positioning portion (34) located corresponding to the second contact portion (18) of the second rail (12);
a resilient portion (36) extending from the arm (30) and toward the release portion (26), the resilient portion (36) connected to the second rail (12) and providing a resilient force to keep the retaining hole (32) of the arm (30) facing the first installation hole (20a) of the second rail (12);
the first installation hole (20a) of the second rail (12) engaged with a first installation member (40a) of an exterior equipment (38), the second installation hole (20b) of the second rail (12) engaged with a second installation member (40b) of the exterior equipment (38), the retaining hole (32) of the arm (30) of the retaining member (22) accommodating the first installation member (40a), the positioning portion (34) of the arm (30) contacting the second contact portion (18) of the second rail (12), the first installation member (40a) located in the first installation hole (20a) by the retaining member (22);
when a force is applied to the release portion (26), the arm (30) of the retaining member (22) being moved relative to the second rail (12) and the positioning portion (34) of the retaining member (22) is disengaged from the second contact portion (18) of the second rail (12), so that the first installation member (40a) is released from the first installation hole (20a) of the second rail (12) and the retaining hole (32) of the retaining member (22).

2. The installation device as claimed in claim 1, wherein the base (24) of the retaining member (22) has a notch (25) which is located corresponding to the first contact portion (16) of the second rail (12).

3. The installation device as claimed in claim 1, wherein the arm (30) of the retaining member (22) has two wings (42) respectively on two sides thereof.

4. The installation device as claimed in claim 1, wherein the first contact protrusion (16) of the second rail (12) is an L-shaped protrusion.

5. The installation device as claimed in claim 1, wherein the second contact portion (18) of the second rail (12) is a hole and the positioning portion (34) of the retaining member (22) is inserted into the hole.

6. The installation device as claimed in claim 1, wherein the retaining hole (32) of the retaining member (22) has a stop (44) protruding from an inside thereof and the stop (44) is located above the first installation hole (20a) of the second rail (12).

7. The installation device as claimed in claim 1, wherein the second installation hole (20b) has a protrusion (21) extending from an inner wall thereof.

## Patentansprüche

1. Ein Montagemechanismus für einen gleitbaren Zusammenbau, aufweisend:
einer ersten Schiene (10);
einer zweiten Schiene (12), die der Länge nach an der ersten Schiene (10) beweglich ist; die zweite Schiene (12) eine Öffnung (14), ein erstes Kontaktelement (16), ein zweites Kontaktelement (18) und mehrere Löcher, einschließlich ein erstes Montageloch (20a) und ein zweites Montageloch (20b), aufweist; das erste Kontaktelement (16) von einer Innenwand der Öffnung (14) ragt; das erste Montageloch (20a) zwischen der Öffnung (14) und dem zweiten Kontaktelement (18) gebildet ist;
einem Sicherungselement (22) mit einer Basis (24), die mit dem ersten Kontaktelement (16) der zweiten Schiene (12) in Berührung kommt; ein Ausrückteil (26) von der Basis (24) ragt; sich ein gebogenes Teil (28) vom Ausrückteil (26) erstreckt und an einem Ausleger (30) befestigt ist; der Ausleger (30) mit der zweiten Schiene (12) in Berührung kommt, so dass das Ausrückteil (26) in einem Abstand zur zweiten Schiene (12) angeordnet ist;
der Ausleger (30) vom gebogenen Teil (28) und über das erste Montageloch (20a) der zweiten Schiene (12) hinaus ragt; der Ausleger (30) ein Sicherungsloch (32) und ein Positionierteil (34) aufweist; das Sicherungsloch (32) entsprechend dem ersten Montagloch (20a) der zweiten Schiene (12) gebildet ist; das Positionierteil (34) entsprechend dem zweiten Kontaktelement (18) der zweiten Schiene (12) angeordnet ist;
einer flexiblen Lasche (36), die sich vom Ausleger (30) und zum Ausrückteil (26) erstreckt; die flexible Lasche (36) an der zweiten Schiene (12) befestigt ist, wobei mit dieser flexiblen Lasche (36) eine Federkraft erzeugt wird, mit der das Sicherungsloch (32) des Auslegers (30) gegenüber dem ersten Montageloch (20a) der zweiten Schiene (12) gehalten wird;
ein erstes Montageelement (40a) einer Außenausstattung (38) in das erste Montageloch (20a) der zweiten Schiene (12) eingerückt ist; ein zweites Montageelement (40b) der Außenausstattung (38) in das zweite Montageloch (20b) der zweiten Schiene (12) eingerückt ist; das erste Montageelement (40a) im Sicherungsloch (32) des Auslegers (30) am Sicherungselement (22) aufgenommen ist; das Positionierteil (34) des Auslegers (30) mit dem zweiten Kontaktelement (18) der zweiten Schiene (12) in Berührung kommt; das erste Montageelement (40a) mit dem Sicherungselement (22) im ersten Montageloch (20a) aufgenommen ist;
beim Ausüben einer Kraft auf das Ausrückteil (26) der Ausleger (30) am Sicherungselement (22) an der zweiten Schiene (12) bewegt und das Positionierteil (34) am Sicherungselement (22) aus dem zweiten Kontaktelement (18) der zweiten Schiene (12) ausgerückt wird, um das erste Montageelement (40a) aus dem ersten Montageloch (20a) der zweiten Schiene (12) und aus dem Sicherungsloch (32) des Sicherungselements (22) auszurücken.

2. Der Montagemechanismus nach Anspruch 1, wobei die Basis (24) des Sicherungselements (22) entsprechend dem ersten Kontaktelement (16) der zweiten Schiene (12) eine Einkerbung (25) aufweist.

3. Der Montagemechanismus nach Anspruch 1, wobei der Ausleger (30) des Sicherungselements (22) auf zwei Seiten je mit einem Flansch (42) gebildet ist.

4. Der Montagemechanismus nach Anspruch 1, wobei das erste Kontaktelement (16) der zweiten Schiene (12) als einen L-förmigen Vorsprung gebildet ist.

5. Der Montagemechanismus nach Anspruch 1, wobei das zweite Kontaktelement (18) der zweiten Schiene (12) als ein Loch gebildet ist, in das das Positionierteil (34) des Sicherungselements (22) eingesetzt ist.

6. Der Montagemechanismus nach Anspruch 1, wobei das Sicherungsloch (32) des Sicherungselements (22) einen Anschlag (44) aufweist, der von einer Innenseite in diesem Sicherungsloch (32) vorsteht, wobei dieser Anschlag (44) über dem ersten Montageloch (20a) der zweiten Schiene (12) gebildet ist.

7. Der Montagemechanismus nach Anspruch 1, wobei das zweite Montageloch (20b) einen Vorsprung (21) aufweist, der von dessen Innenwand ragt.

## Revendications

1. Un dispositif d'installation pour un ensemble coulissant, comprenant :
un premier rail (10) ;
un second rail (12) déplaçable longitudinalement par rapport au premier rail (10), le second rail (12) ayant une ouverture (14), une première partie de contact (16), une seconde partie de contact (18) et de multiples trous comprenant au moins un premier trou d'installation (20a) et un second trou d'installation (20b), la première partie de contact (16) en extension à partir d'une paroi interne de l'ouverture (14), le premier trou d'installation (20a) situé entre l'ouverture (14) et la seconde partie de contact (18) ;
un élément de retenue (22) ayant une base (24) en contact avec la première partie de contact (16) du second rail (12), une partie de désengagement (26) en extension à partir de la base (24), une partie courbée (28) en extension à partir de la partie de désengagement (26) et raccordée avec un bras (30), le bras (30) en contact avec le second rail (12) de sorte que la partie de désengagement (26) est située à l'écart du second rail (12) ;
le bras (30) en extension à partir de la partie courbée (28) et au-delà du premier trou d'installation (20a) du second rail (12), le bras (30) ayant un trou de retenue (32) et une partie de positionnement (34), le trou de retenue (32) situé en correspondance avec le premier trou d'installation (20a) du second rail (12), la partie de positionnement (34) située en correspondance avec la seconde partie de contact (18) du second rail (12) ;
une partie élastique (36) en extension à partir du bras (30) et vers la partie de désengagement (26), la partie élastique (36) raccordée au second rail (12) et fournissant une force élastique pour conserver le trou de retenue (32) du bras (30) en face du premier trou d'installation (20a) du second rail (12) ;
le premier trou d'installation (20a) du second rail (12) engagé avec un premier élément d'installation (40a) d'un équipement extérieur (38), le second trou d'installation (20b) du second rail (12) engagé avec un second élément d'installation (40b) de l'équipement extérieur (38), le trou de retenue (32) du bras (30) de l'élément de retenue (22) accueillant le premier élément d'installation (40a), la partie de positionnement (34) du bras (30) en contact avec la seconde partie de contact (18) du second rail (12), le premier élément d'installation (40a) situé dans le premier trou d'installation (20a) grâce à l'élément de retenue (22) ;
quand une force est appliquée à la partie de désengagement (26), le bras (30) de l'élément de retenue (22) étant déplacé par rapport au second rail (12) et la partie de positionnement (34) de l'élément de retenue (22) est désengagée de la seconde partie de contact (18) du second rail (12), de sorte que le premier élément d'installation (40a) est désengagé du premier trou d'installation (20a) du second rail (12) et du trou de retenue (32) de l'élément de retenue (22).

2. Le dispositif d'installation selon la revendication 1, dans lequel la base (24) de l'élément de retenue (22) a une encoche (25) qui est située en correspondance avec la première partie de contact (16) du second rail (12).

3. Le dispositif d'installation selon la revendication 1, dans lequel le bras (30) de l'élément de retenue (22) a deux ailes (42) respectivement situées sur deux de ses côtés.

4. Le dispositif d'installation selon la revendication 1, dans lequel la première saillie de contact (16) du second rail (12) est une saillie en forme de L.

5. Le dispositif d'installation selon la revendication 1, dans lequel la seconde partie de contact (18) du second rail (12) est un trou et la partie de positionnement (34) de l'élément de retenue (22) est insérée dans le trou.

6. Le dispositif d'installation selon la revendication 1, dans lequel le trou de retenue (32) de l'élément de retenue (22) a un arrêt (44) en saillie à partir de son intérieur et l'arrêt (44) est situé au dessus du premier trou d'installation (20a) du second rail (12).

7. Le dispositif d'installation selon la revendication 1, dans lequel le second trou d'installation (20b) a une protrusion (21) en extension à partir d'une paroi interne de celui-ci.
